# EUROPÄISCHE PATENTSCHRIFT

(11) **EP 1 420 900 B1**
(45) Veröffentlichungstag und Bekanntmachung des Hinweises auf die Patenterteilung: **23.11.2005**
(21) Anmeldenummer: 02767131.2
(22) Anmeldetag: 29.08.2002
(51) Int. Cl.: B21C 1/00, B21C 37/02, H01L 39/24, B21C 1/02

(54) **VERFAHREN ZUR HERSTELLUNG METALLISCHER BÄNDER**
METHOD FOR PRODUCING METALLIC STRIPS
PROCEDE POUR PRODUIRE DES BANDES METALLIQUES

(30) Priorität: 30.08.2001 DE 10143680
(43) Veröffentlichungstag der Anmeldung: 26.05.2004
(73) Patentinhaber: Leibniz-Institut für Festkörper- und Werkstoffforschung Dresden e.V., 01069 Dresden (DE)
(72) Erfinder: EICKEMEYER, Jörg, 01279 Dresden (DE); SELBMANN, Dietmar, 01738 Colmnitz (DE); OPITZ, Ralph, 01108 Dresden (DE)
(74) Vertreter: Rauschenbach, Marion
(86) Internationale Anmeldenummer: PCT/DE2002/003193
(87) Internationale Veröffentlichungsnummer: WO 2003/024637

(56) Entgegenhaltungen:
- WO-A-99/16941
- DE-B- 1 184 969
- GB-A- 519 604
- US-A- 3 318 129
- US-A- 5 089 057
- US-A- 5 981 444
- US-B1- 6 180 570

## Beschreibung

### Technisches Gebiet

Die Erfindung betrifft ein Verfahren zur Herstellung metallischer Bänder auf der Basis von Nickel, Kupfer, Aluminium, Silber oder den Legierungen dieser Metalle, die nach vorausgehender Umformung eine hochgradige Glühtextur mit Würfellage aufweisen.

Das Verfahren ist grundsätzlich auf alle metallischen Werkstoffe anwendbar, die nach Kalt- oder auch Warmumformung und sich daran anschließende Rekristallisation zur Ausbildung der Würfeltextur neigen. Hierzu zählen die metallischen Werkstoffe mit kubisch-flächenzentriertem Gitter, wie Nickel, Kupfer, Gold und unter besonderen Bedingungen Silber sowie ein Teil ihrer Legierungen, eingeschlossen die austenitischen Fe-Ni-Legierungen, Für Aluminium trifft dies dagegen nach einer Warmumformung durch Walzen zu.

Die nach dem neuen Verfahren hergestellten Bänder sind beispielsweise einsetzbar als Unterlage für physikalischchemische Beschichtungen mit hochgradiger mikrostruktureller Ausrichtung. Die Textur dient dabei als Basis für ein kristallografisch orientiertes Aufwachsen der abgeschiedenen Schichten auf dem Substrat. Solche Unterlagen sind zum Beispiel als Substrate für keramische Beschichtungen geeignet, wie sie auf dem Gebiet der Hochtemperatur-Supraleitung angewendet werden. Die Substratfunktion als epitaktische Unterlage ist an einen möglichst perfekten Texturzustand gebunden und erfordert daher ein Höchstmaß an Ausrichtung des polykristallinen Gefüges. Der Einsatz solcher Substratbändern für Schicht-Supraleiter erfolgt in supraleitenden Magneten, Transformatoren, Motoren, Tomographen oder supraleitenden Strombahnen.

### Stand der Technik

Bekannt ist, dass polykristalline Metalle mit kubisch-flächenzentriertem Gitter, wie Kupfer, Nickel, Gold und unter bestimmten Bedingungen auch Silber nach vorausgegangener starker Kaltumformung durch Walzen bei der nachfolgenden Rekristallisation eine ausgeprägte Textur mit Würfellage ausbilden können (G. Wassermann: Texturen metallischer Werkstoffe, Springer, Berlin, 1939; H. Hu u.a.: Trans. ASM 224(1962)96-105). Die grundlegenden Arbeiten (W. Köster: Z. Metallkde. 18(1926)112-116) und auch die weiter führenden Untersuchungen (R. D. Doherty u.a.: Mater. Sci. Eng. A257(1998)18-36) wurden auf der Basis des Bandwalzens mit anschließender Glühbehandlung durchgeführt.

Auf diese Weise durch Walzen und Glühen texturierte Metallbänder, insbesondere Nickel- und Silberbänder, werden heute auch als Unterlage für metallische Überzüge, keramische Pufferschichten und keramische Supraleiterschichten benutzt (US 5 741 377). Die Eignung solcher Metallbänder als Substratwerkstoff hängt maßgeblich vom erreichbaren Grad der Texturierung sowie ihrer Qualität unmittelbar auf der Oberfläche ab.

Bekannt ist auch, dass durch Legieren reiner Metalle mit anderen Elementen der Grad der Texturausbildung mit wachsendem Legierungsgehalt im allgemeinen stark abnimmt (R. E. Smallman: Journ. Inst. Metals 84(1955-56)10-18). Beispielsweise gilt für Aluminium, dass durch Eisen bereits bei sehr geringen Gehalten im Bereich von 10 bis 300 ppm die Rekristallisationstemperatur des Aluminiums angehoben wird, die Würfeltextur hingegen deutlich schwächer wird (W. B.

Hutchinson, H.-E. Ekström: Mater. Sci. Technol. 6(1990)1103-1111). Ein sehr starker negativer Einfluß von Magnesium auf die Texturierbarkeit von Nickel wurde ebenfalls nachgewiesen (K. Detert u.a.: Z. Metallkde. 54(1963)263-270). Es genügen 600 Atom-ppm, um die Herausbildung der Würfeltextur zu verhindern. Hinsichtlich der Erhöhung der Rekristallisationstemperatur des Nickels sind ebenfalls Elementwirkungen nachgewiesen (K. Detert, G. Dressler: Acta Metall. 13(1965)845-853). Das trifft zum Beispiel für Chrom und Molybdän als Legierungselemente zu. Andererseits ist deren spezifische Wirkung auf die Schärfe und die thermische Stabilität der Glühtextur, insbesondere für Gehalte ihrer Löslichkeit im Nickel, nicht klar. Es wurde gefunden, dass bei 3 Atom-% Molybdän eine Würfeltextur nicht mehr erzielbar ist (K. Detert u.a.: Z. Metallkde. 54(1963)263-270).

Bei höheren Legierungsgehalten ist zu erwarten, dass beispielsweise die primäre Rekristallisationstextur des Nickels als Würfeltextur weniger vollständig ausgebildet wird, wie für Nickel-Molybdän- und Nickel-Wolfram-Legierungen gezeigt wurde (J. Eickemeyer u.a.: Supercond. Sci. Technol. 14(2001)152-159). Darüber hinaus ist bei höheren Temperaturen mit einem Abbau der primär gewachsenen Würfeltextur durch sekundäre Rekristallisationsvorgänge zu rechnen (R. E. Smallman, C. S. Lee: Mater. Sci. Eng. A184(1994)97-112). Solche höheren Temperaturen werden mit 700°C bis 800°C bei den üblichen Beschichtungsbedingungen, wie sie beim Abscheiden supraleitender Schichten vorliegen, erreicht.

Neben den chemischen Legierungseinflüssen auf die Texturqualität ist die Ausbildung der Rekristallisations-Würfeltextur vor allem auch an spezifische mechanische, umformtechnische Voraussetzungen gekoppelt. Unabdingbar ist ein hoher Mindestumformgrad beim Kaltwalzen, wobei ein feinkörniges Ausgangsgefüge des Umformgutes vorteilhaft ist. Für Kupfer beträgt der Mindestumformgrad 82% (O. Dahl, F.

Pawlek: Z. Metallkde. 28(1936)266-271). Um hochgradig zu texturieren werden allerdings wesentlich höhere Umformgrade aufgebracht, die zum Teil über 99% Dickenreduktion betragen. Diese umformtechnisch sehr aufwändige Herstellungstechnologie wird gegenwärtig in Kauf genommen, da alternative Techniken seit Jahrzehnten nicht gesehen werden.

Andere Formgebungsverfahren als das Walzen spielen somit bei der Herstellung von Metallbändern mit Würfeltextur derzeit praktisch keine Rolle. Die Ursache hierfür liegt nicht zuletzt in den fehlenden experimentellen Untersuchungen bezüglich der Eignung anderer Umformverfahren zur Bandherstellung, da diese gerade wegen der erwiesenen großen Effektivität des Walzens bei der Bandherstellung bisher nicht interessant waren.

Eine allgemeingültige Theorie über die Wirkungen von Spannungs- und Deformationszuständen auf die Ausbildung der Umform- und Glühtexturen der Metalle, bzw. im besonderen des Nickels, Kupfers, Golds und Silbers gibt es nicht. Es ist deshalb nicht möglich, die Wirksamkeit eines Umformverfahrens auf die Ausbildung der Verformungs- und Glühtexturen sicher zu berechnen. Darüber hinaus beeinflussen auch die Reibungsbedingungen zwischen Umformgut und Umformwerkzeug die Texturformierung in Bändern, und insbesondere in dünnen Bändern, in bisher nicht vorhersagbarer Weise.

Mit dem wachsenden Interesse an weitgehend idealen Glühtexturen für die Anwendung von Bändern als sehr lange, quasi-einkristalline Substrate (supraleitende Schichtleiter) steht zugleich die Forderung nach einer möglichst perfekten Textur nicht nur im Bandinneren, sondern insbesondere auf der Oberfläche solcher Beschichtungsunterlagen. Aus diesem Grunde sind sämtliche für die Texturausbildung eventuell störenden Einflüsse kritisch zu bewerten und nach Möglichkeit abzuwenden. Nicht zuletzt gilt dies für die optimalen Verfahrensbedingungen bei der Werkstoffumformung, die bisher auf die Einflussgrößen beim Walzen begrenzt sind.

### Darstellung der Erfindung

Der Erfindung liegt die Aufgabe zu Grunde, ein Verfahren zur Herstellung metallischen Bändern mit hochgradiger Würfeltextur auf der Basis von Nickel, Kupfer, Aluminium, Silber oder den Legierungen dieser Metalle zu entwickeln, das im Vergleich zur üblichen Walzumformung bei geringeren Gesamtumformgraden eine qualitativ gleichwertige Rekristallisations-Würfellage beim anschließenden Glühprozess ermöglicht, bzw. das bei vergleichbaren Gesamtumformgraden eine qualitativ bessere Würfeltextur erzeugt.

Erfindungsgemäß werden die Werkstoffe vor ihrer Rekristallisationsglühung hochgradig durch Kaltziehen umgeformt, wobei als Werkzeuge
a) nicht angetriebene Rollenapparate mit einem achsparallelen, flachen Rollenpaar oder Türkenkopf-Anordnungen mit zwei Rollenpaaren
   oder
b) feststehende, gegeneinander geneigte Ziehbacken
benutzt werden.

Die erfindungsgemäß vorgesehenen Werkzeugart der nicht angetriebenen Rollenpaare ist beispielsweise beschrieben in F. Dohmann, R. Kopp und J. Mittendorff: Durchziehen; in: Umformtechnik, Plastomechanik und Werkstoffkunde, Hersg.: W. Dahl, R. Kopp und O. Pawelski, Verlag Stahleisen, Düsseldorf, 1993, S. 792.

Kenntnisse über nicht angetriebene Türkenkopf-Werkzeuge kann der Fachmann beispielsweise aus J. A. Schey: Tribology in Metal Working, ASM, Metals Park, Ohio, 1984, S. 352 entnehmen.

Die erfindungsgemäß vorgesehen feststehenden Ziehbacken sind beispielsweise beschrieben von S. Kalpakjian in Manufacturing Processes for Engineering Materials, Addison-Wesley Publishing Company, Reading, Mass., 1991, S. 384.

Gemäß einer Ausgestaltung der Erfindung wird das Kaltziehen mit einer Dickenreduktion von εₕ > 50%, vorzugsweise von εₕ > 90%, durchgeführt.

Vorteilhaft kann das Kaltziehen kombiniert werden mit einer für schwer umformbare Legierungen üblichen Walzumformung.

Dabei sollte das Verfahren des Kaltziehens im überwiegenden Maße angewandt werden.

Vorteilhaft ist es, wenn eine abschließende Oberflächenglättung der Bänder mittels Feinwalzung oder mittels einem anderen Verfahren der Feinbearbeitung von Oberflächen, insbesondere mittels Prägepolieren, durchgeführt wird.

Die Verfahrensart des Prägepolierens ist beispielsweise beschrieben in W. Machu: Oberflächenvorbehandlung von Eisen- und Nichteisenmetallen, Akademische Verlagsgesellschaft Geest & Portig, Leipzig, 1957, S. 850.

Die mit dem erfindungsgemäßen Verfahren bearbeiteten metallischen Werkstoffe werden schließlich in reduzierender oder nichtoxidierender Atmosphäre einer rekristallisierenden Glühung zur Erzielung der Würfeltextur unterworfen. Die rekristallisierende Glühung wird bei Temperaturen ausgeführt, die dem Fachmann bekannt sind.

Durch das erfindungsgemäße Verfahren wird der relative Texturgrad der Würfellage nach Kaltziehen und Glühen bei deutlich geringeren Dickenreduktionen erreicht, als es bei der Anwendung des bisher benutzten Kaltwalzens der Fall ist. Dieser Vorteil des Durchziehens gegenüber dem Walzen tritt sowohl beim Walzziehen mittels Rollenwerkzeugen als auch beim Gleitziehen auf, wobei das Walzziehen effektiver wirkt.

Obwohl die Verfahren des Durchziehens altbekannte Umformverfahren sind, ist ihr Einfluss auf die Umform- und Glühtexturen in Metallbändern bisher nicht ausreichend untersucht worden. Der Grund hierfür liegt darin, dass die Fertigung von Bändern aus fertigungstechnischen und ökonomischen Gründen eindeutig die Domäne der Walzumformung ist. Für Spezialbehandlungen, wie der Erzielung einer hochgradigen Würfeltextur, zeigte sich daher in überraschender Weise der positive Einfluss der Ziehverfahren, insbesondere der des Walzziehverfahrens.

Für die Anwendung des erfindungsgemäßen Verfahrens auf die Herstellung von Substratbändern ergibt sich damit die Möglichkeit, Bänder herzustellen, die aufgrund ihrer schwierigen Texturierbarkeit über das Kaltwalzen und Glühen nicht in der nötigen Qualität gefertigt werden können. Die Erleichterung der Texturformierung beim Glühen infolge des vorausgegangenen Kaltziehens erweitert somit die technologischen Möglichkeiten. Hierin liegt der wesentliche, spezielle Vorteil für das neue Verfahren. Hinzu kommt, dass bei gleichem Grad der Würfeltextur ein gezogenes Band weniger umgeformt werden muss, als ein gewalztes. Dadurch werden zwangsläufig Energie und Arbeitsaufwand gespart.

Die schmelzmetallurgische Herstellung der zu texturierenden Metalle und Legierungen erfolgt vorzugsweise durch Gießen in eine Kupferkokille. Auch eine pulvermetallurgische Herstellung über kalt- und heißisostatisches Pressen kann für das Ausgangsmaterial alternativ zur schmelzmetallurgischen Herstellung zweckmäßig sein.

Die metallurgisch hergestellten Guss- oder Presskörper können vor Beginn der nachfolgenden üblichen Warmumformung durch eine Homogenisierungsglühung ein vorteilhaftes Ausgangsgefüge erhalten sowie eine kontrollierte Einstellung der Korngröße für die abschließende starke Kaltumformung. Der Warmumformgrad, wie auch die Temperatur und Dauer der Glühung können leicht vom Fachmann unter dem Aspekt der guten Kaltumformbarkeit im weiteren Prozess optimiert werden. Die Glühatmosphäre für die Rekristallisation ist zweckmäßigerweise reduzierend oder inert. Die Glühtemperaturen und -zeiten tendieren mit zunehmendem Legierungsgehalt zu höheren Werten und können ebenfalls unproblematisch vom Fachmann eingestellt werden.

Die im Sinne einer verbesserten Texturbildung wirkende Ziehumformung beim Walzziehen kann sowohl als alleiniges Umformverfahren zur Texturierung angewendet werden, es kann aber auch als Hauptverfahren in Kombination mit anderen Verfahren genutzt werden, wie mit dem Gleitziehen oder Walzen. Es obliegt dem Fachmann einzuschätzen, inwieweit das Umformvermögen des zu texturierenden Bandes ein Walzziehen oder Gleitziehen zulässt, um die positive Wirkung des erfindungsgemäßen Verfahrens weitestgehend zum Tragen zu bringen.

Während die mit Hilfe des Walzens hergestellten texturierten Bänder unter dem Namen RABiTS (Rolling Assisted Biaxially Textured Substrates) geschützt wurden (US 5 741 377), wird vom Anmelder für die erfindungsgemäß hergestellten Bänder die neue Kurzbezeichnung DABiTS (Drawing Assisted Biaxially Textured Substrates) eingeführt.

### Wege zur Ausführung der Erfindung

Die Erfindung ist nachstehend anhand von Beispielen näher erläutert. In den zugehörigen Zeichnungen zeigen:
- Fig. 1:: Röntgenografische (111)-Polfiguren von Nickel mit Würfeltextur nach unterschiedlichen Dickenabnahmen durch Walzziehen (WZ 0,5 = 95%; WZ 0,18 = 98,2%; WZ 0,08 = 99,2%) und Rekristallisation bei 600°C über 30 min in Wasserstoffgas,
- Fig. 2:: Röntgenografische (111)-Polfiguren von Nickel mit Würfeltextur nach unterschiedlichen Dickenabnahmen durch Kaltwalzen (W 0,5 = 95%; W 0,18 = 98,2%; W 0,08 = 99,2%) und Rekristallisation bei 600°C über 30 min in Wasserstoffgas,
- Fig. 3:: Halbwertsbreiten der röntgenografischen (111)-Pole von Nickelbändern mit Würfeltextur nach unterschiedlichen Dickenabnahmen durch Walzziehen, Gleitziehen und Walzen sowie anschließender Rekristallisation bei 800°C über 30 min in Wasserstoffgas,
- Fig. 4:: Diagramm zum Einfluss des Umformverfahrens und des Umformgrades auf den Grad der Ausbildung der Rekristallisations-Würfeltextur in Nickelbändern. In dieser Figur wird an Stelle von Polfiguren der Lotgeringfaktor I₍₁₀₀₎ zur Charakterisierung des Grades der Würfeltextur verwendet.

### Beispiel 1

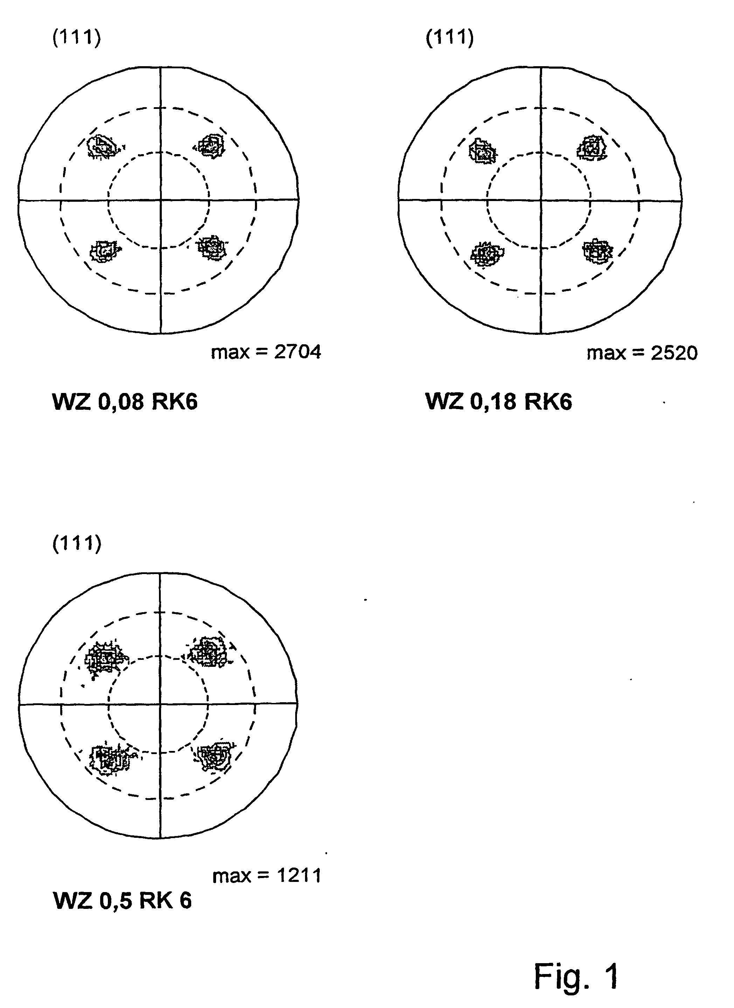

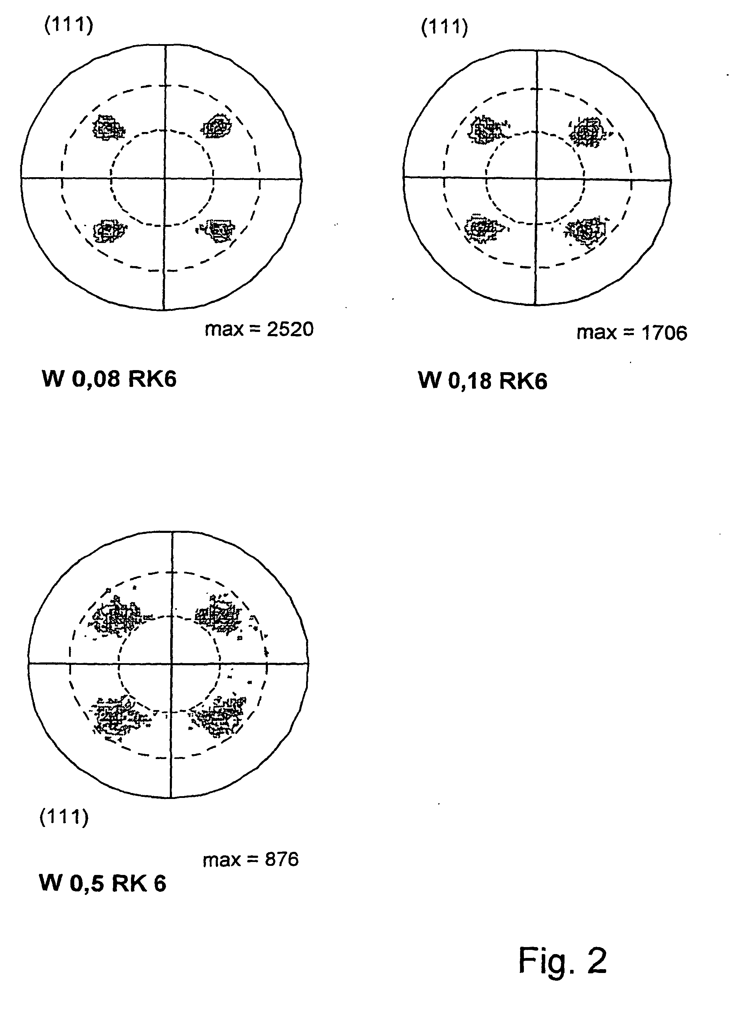

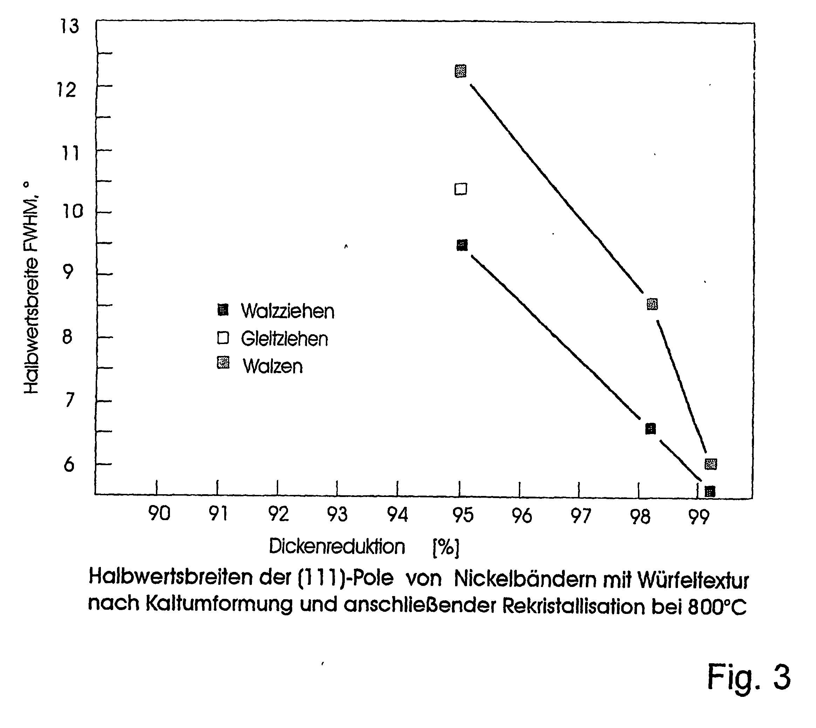

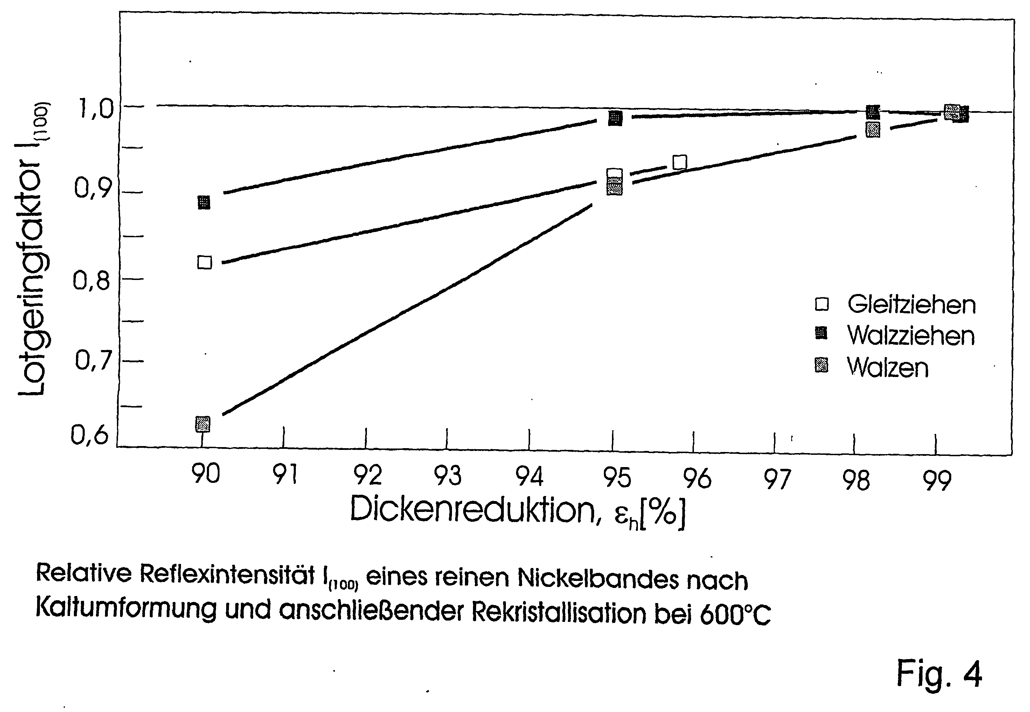

Technisch reines Nickel-Stabmaterial mit einem Reinheitsgrad von 99,9 Atom-% Nickel und einer Ausgangsabmessung von 10 mm x 10 mm wird weichgeglüht. Anschließend wird zur Erzeugung der Würfeltextur an eine Banddicke von 0,5 mm (εₕ = 95%) durch frei drehbare Rollen walzgezogen und bei 600°C geglüht. Es entsteht eine scharfe Würfeltextur, wie Fig.1 belegt. Die gemessenen Intensitäten in der Polfigur (WZ 0,5 RK6) sind deutlich höher als nach vorausgehender Walzumformung (Fig.2, W 0,5 RK6). Die Maximalwerte der Intensitäten betragen 1211 nach Walzziehen und Glühen und 876 nach Walzen und Glühen. Das Walzziehen führt somit zu einer um 38% höheren maximalen Intensität gegenüber dem Kaltwalzen. Bezüglich der für die Texturschärfe repräsentativen Halbwertsbreiten (FWHM-Werte) ergibt sich durch die Anwendung des Ziehens eine wesentliche Verbesserung (Fig. 3). Bei gleicher Dickenreduktion von εₕ = 95% resultieren nach der Wärmebehandlung bei 800°C folgende FWHM-Werte: a) Walzen: 12,21, b) Gleitziehen: 10,41 und c) Walzziehen: 9,46. Der mittels Walzen erreichte FWHM-Wert ist damit 29% schlechter als der mittels Walzziehen erzielte (Fig. 3). Noch klarer zeigt sich der positive Einfluss des Walzziehens bei geringerer Umformung. Bei 1 mm Banddicke (εₕ = 90%) betragen die Lotgeringfaktoren nach dem Walzziehen I₍₁₀₀₎ = 0,88 und nach dem Walzen I₍₁₀₀₎ = 0,63. Die relative Verbesserung durch das Walzziehen ist 40% (Fig.4).

Wie Fig. 4 zeigt, wird nach dem Walzziehen ein I₍₁₀₀₎ ≈ 1,0 bereits nach 95% Dickenreduktion erreicht, wogegen dafür beim Walzen etwa 99% nötig sind. Um den bei einer Materialdicke von 500 µm infolge des Walzziehens erreichten Texturzustand auch durch Walzen zu erreichen, muss bis an etwa 100 µm weiter umgeformt werden (Fig.4).

Wie die Ergebnisse in den Figuren 3 und 4 belegen, ist nicht nur das Walzziehen, sondern auch das Gleitziehen für die Formierung der Würfeltextur in Nickel günstiger als das Walzen. Dieser günstige Einfluss des Gleitziehens überrascht, da früher durch Gleitziehen von Kupfer im Vergleich zum Walzen lediglich ein gleichwertiger Einfluss festgestellt wurde (W. M. Baldwin: Trans. ASM 39(1947)737-739), was technologisch nicht attraktiv erschien und offenbar deshalb nicht weiter verfolgt wurde.

### Beispiel 2

Technisch reines Nickel mit einem Reinheitsgrad von 99,9 Atom-% Nickel, wird nach dem Abguss in eine Kupferkokille von ca. 40mm X 40mm Querschnitt spanabhebend überarbeitet, danach an 20 mm x 20 mm warmgewalzt und homogenisierend bei 1050°C geglüht. Zur Einstellung eines feinkörnigen Gefüges wird an 10 mm x 10 mm Querschnitt kaltgewalzt und rekristallisierend geglüht. Ab 10 mm Dicke wird an 2,5 mm Dicke gleitgezogen. Darauf erfolgt die Kaltumformung durch Walzziehen an die Enddicke von 0,25 mm. Es wird eine Wärmebehandlung bei 800°C angeschlossen, um die hochgradige Würfeltextur in dem Nickelband zu erzeugen.

### Beispiel 3

Eine Nickellegierung mit einem Legierungsgehalt von 5 Atom-% Wolfram wird von der Querschnittsabmessung (20 x 20)mm² an die Dicke von 3 mm kaltgewalzt und bei 850°C zur Einstellung eines feinkristallinen Gefüges rekristallisiert. Ab 3 mm Dicke wird an 0,15 mm Dicke walzgezogen und bei 1000°C zur Erzielung der hochgradigen Würfeltextur geglüht. Es ist aber auch möglich, das Walzziehen nur bis 0,20 mm Materialdicke auszuführen und ein Schlusswalzen an 0,15 mm mit polierten Walzen vorzunehmen, um eine möglichst hohe Oberflächenqualität des Bandes mit minimaler Rauhigkeit zu erreichen.

### Beispiel 4

Kupferblech der Dicke 10 mm wird nach einer Ausgangsglühung zur Erzeugung eines weichen Gefüges an die Fertigabmessung von 0,08 mm Dicke durch frei drehbare Rollen kaltgezogen. Während der nachgeschalteten halbstündigen Wärmebehandlung bei 400°C entsteht eine scharfe Würfeltextur im Bandmaterial.

## Patentansprüche

1. Verfahren zur Herstellung metallischer Bänder mit Rekristallisations-Würfeltextur auf der Basis von Nickel, Kupfer, Aluminium, Silber oder den Legierungen dieser Metalle, einschließlich austenitischer Eisen-Nickel-Legierungen, **dadurch gekennzeichnet, dass** die Werkstoffe vor ihrer Rekristallisationsglühung hochgradig durch Kaltziehen umgeformt werden, wobei als Werkzeuge
a) nicht angetriebene Rollenapparate mit einem achsparallelen, flachen Rollenpaar oder Türkenkopf-Anordnungen mit zwei Rollenpaaren
oder
b) feststehende, gegeneinander geneigte Ziehbacken
benutzt werden.

2. Verfahren nach Anspruch 1, **dadurch gekennzeichnet, dass** das Kaltziehen mit einer Dickenreduktion von εₕ > 50%, vorzugsweise von εₕ > 90%, durchgeführt wird.

3. Verfahren nach Anspruch 1, **dadurch gekennzeichnet, dass** das Kaltziehen kombiniert wird mit einer für schwer umformbare Legierungen üblichen Walzumformung.

4. Verfahren nach Anspruch 3, **dadurch gekennzeichnet, dass** bei der kombinativen Anwendung von Kaltziehen und Walzumformung das Verfahren des Kaltziehens im überwiegenden Maße angewandt wird.

5. Verfahren nach Anspruch 1, **dadurch gekennzeichnet, dass** eine abschließende Oberflächenglättung der Bänder mittels Feinwalzung oder mittels einem anderen Verfahren der Feinbearbeitung von Oberflächen, insbesondere mittels Prägepolieren, durchgeführt wird.

## Claims

1. A method for producing metallic strips with recrystallization cube texture on the basis of nickel, copper, aluminium, silver or the alloys of these metals, including austenitic iron-nickel alloys, **characterized in that** the materials are intensively deformed by cold drawing with special tools before the recrystallization heat treatment is performed:
a) a roller die equipment with an axially parallel, roller-pair, which is not driven, or a turk-head arrangement with two pairs of rollers, or
b) stationary, mutually inclined rigid flat drawing jaws.

2. The method of claim 1, **characterized in that** the cold drawing is carried out with a reduction of thickness εₕ of more than 50 % and preferably more than 90 %.

3. The method of claim 1, **characterized in that** the cold drawing is combined with cold rolling as usual for alloys which are difficult to deform.

4. The method of claim 3, **characterized in that** a combined cold drawing and cold rolling process is applied using cold drawing as the predominant processing method.

5. The method of claim 1, **characterized in that** a final surface smoothing of the strips is carried out by means surface rolling or by means of a different method of fine deformation finishing.

## Revendications

1. Procédé de fabrication de feuillards métalliques à structure cubique de recristallisation et à base de nickel, de cuivre, d'aluminium, d'argent ou des alliages de ces métaux, notamment des alliages austénitiques de fer-nickel, **caractérisé en ce qu'**avant leur recuit de recristallisation, les matériaux sont fortement déformés par un étirage à froid dans lequel on utilise comme outils :
a) des appareils de laminage non entraînés dotés d'une paire de rouleaux plats à axes parallèles ou des agencements en tête de Turc avec deux paires de rouleaux ou
b) des mâchoires de traction fixes et inclinées l'une par rapport à l'autre.

2. Procédé selon la revendication 1, **caractérisé en ce que** l'étirage à froid est réalisé jusqu'à une réduction d'épaisseur de εₕ > 50 % et de préférence de εₕ > 90 %.

3. Procédé selon la revendication 1, **caractérisé en ce que** l'étirage à froid est combiné avec le laminage habituel pour les alliages difficilement déformables.

4. Procédé selon la revendication 3, **caractérisé en ce que** lors d'une application combinée d'un étirage à froid et d'un laminage, l'opération de laminage à froid est utilisée dans une mesure prédominante.

5. Procédé selon la revendication 1, **caractérisé en ce que** l'on réalise un lissage final de la surface des feuillards par laminage fin ou au moyen d'un autre procédé de finition de surfaces, en particulier par polissage sous pression.
